# EUROPEAN PATENT APPLICATION

(11) **EP 1 256 846 A2**
(43) Date of publication of application: **13.11.2002**
(21) Application number: 02253142.0
(22) Date of filing: 03.05.2002
(51) Int. Cl.: G03F 7/20, G03F 1/14

(54) **Optical proximity correction**

(30) Priority: 11.05.2001 GB 0111529
(71) Applicant: Zarlink Semiconductor Limited, Swindon, Wiltshire SN2 2QW (GB)
(72) Inventor: Martin, Brian, Plymouth, Devon PL6 6LQ (GB)
(74) Representative: Asquith, Julian Peter

(57) **Abstract**

A method of carrying out optical proximity correction in the design of a reticle for exposing a photoresist in photolithography includes generating a plurality of sets of rules reflecting the relationship between linewidth and line density on the photoresist, each set of rules corresponding to a different region of the image field of the lens, and carrying out optical proximity correction for each region of the image field making use of the corresponding set of rules.

## Description

The invention relates to an improved method of optical proximity correction, and products thereof.

As the resolution limit of an optical lithography tool is approached, the fidelity of printed features is compromised by the size and location of their neighbours, resulting in reduced dimensional control. These "optical proximity" effects include dense-isolated bias, i.e., effects resulting from changing linewidth density.

In photolithography, lines are defined by passing light through a "reticle" which acts as a mask and is typically formed from glass printed with chrome patterns. In order to print lines the reticle is provided with lines and spaces which allow the light to pass through onto the photoresist (a photosensitive layer which covers the substrate which is to be etched using photolithography). Light which passes through the spaces in the reticle prints lines on the photoresist, and these lines can be of varying pitch. For repeating lines the pitch refers to the spacing of the lines, thus the greater the pitch the more isolated the lines. If the wavelength of the light approaches the size of the lines, their thickness (linewidth) can be affected. It is possible to correct for such variations in the printed linewidth on the wafer by changing the linewidths on the reticle. Such corrections are made automatically using optical proximity correction (OPC) software packages, of which there are now several commercially available brands, resulting in selective modification of the linewidths in the reticle design to achieve the desired printed image.

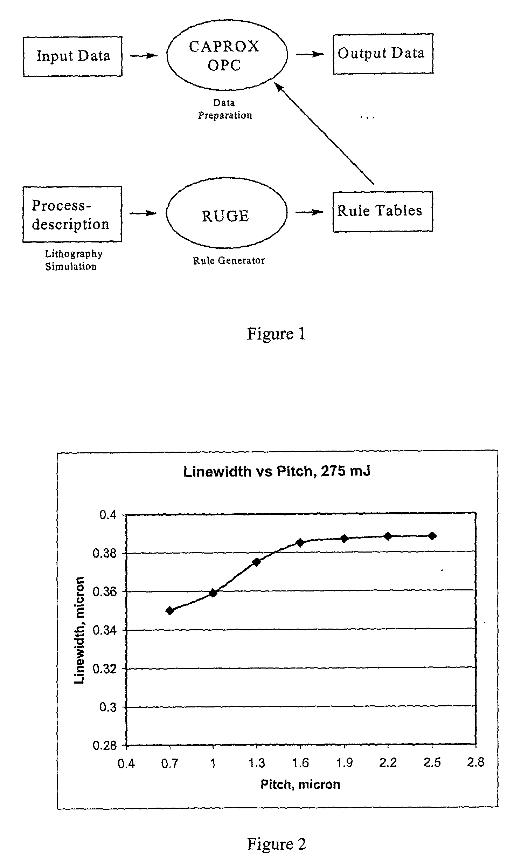

The applicant, Mitel Semiconductor Limited, has already developed a method of applying OPC through lithography simulation using the correction software CAPROX OPC (RTM) in conjunction with the optical lithography simulation tool SOLID-C (RTM), thereby allowing the entire procedure to be carried out without recourse to practical experiment or having restrictions imposed by the limitations of aerial image only correction (described in a paper by Arthur, G., Martin, B., Wallace, C. and Rosenbusch, A. entitled "Full-Chip Optical Proximity Correction using Lithography Simulation" presented at BACUS Photomask Symposium in September 1998.). A flow diagram for using CAPROX (RTM) is shown in Figure 1.

OPC is normally applied at exposure-to-size for dense lines (ie, those having equal line/space ratio) and lines at other pitches are corrected using an appropriate linewidth versus pitch function. Alternatively the exposure-to-size for isolated lines could be used and lines at other pitches corrected. A description of OPC itself is given for example in Wallace, C., Duncan, C. and Martin, B. "Application of Optical Proximity Correction in Manufacturing and its Effect on Process Control" Metrology, Inspection and Process Control for MicrolithographyX1V, SPIE, 2000.

In the application of OPC a set of rules describing a lithography process is defined, from which the proximity correction is made to a data file. However, dimensional variations may arise from imperfections in lens quality when the whole of a stepper lens image field is used to define patterns for critical layers, and these variations are not accounted for by such a set of rules.

In accordance with the invention there is provided a method of carrying out optical proximity correction in the design of a reticle for exposing a photoresist in photolithography using a lens having an image field on the photoresist, the method including:
generating a plurality of sets of rules reflecting the relationship between linewidth and line density of lines on the photoresist, each set of rules corresponding to a different region of the image field; and
carrying out optical proximity correction for each region of the image field making use of the corresponding set of rules.

Thus local imperfections in lens quality can be accounted for when optical proximity correction is carried out.

Each set of rules is preferably generated by measuring the linewidth of lines on the photoresist at a range of line densities in the corresponding region of the image field. In one embodiment, at least one of the sets of rules may be generated by a lithography simulation program arranged to simulate the relationship between the linewidth and line density of lines on the photoresist. The region corresponding to this set of rules may be located substantially in the centre of the image field.

The optical proximity correction may conveniently be carried out using an optical proximity correction program. In a preferred embodiment, each set of rules is stored in a separate data file.

Preferably the lens is optimised for use with 365 nm lithography, although it will be understood that the method according to the invention can be used with lenses optimised for use at other wavelengths, for example 248 nm and 193 nm.

According to another aspect the invention provides a reticle produced by the method described above, and a polysilicon gate produced using such a reticle.

Some preferred embodiments of the invention will now be described by way of example only and with reference to the accompanying drawings, in which:
Figure 1 is a flow diagram showing CAPROX (RTM) and RUGE (RTM); and
Figure 2 shows the variation of linewidth with pitch for a 0.35 µm line.

Referring to Figure 1, it will be seen that the OPC program uses rules which are generated by RUGE (RTM) using the results of a lithography simulation which stimulates the behaviour of the photoresist. When rules for OPC are generated, from lithography simulation or practically, and input to RUGE, they are derived from a linewidth vs. pitch function, the limits of which define the dense-isolated offset - i.e. the difference in linewidth between dense and isolated lines.

In order to define lines in photolithography, light is passed through a reticle which acts as a mask onto a layer of photoresist on a wafer. The light is supplied through a lens which allows the coverage of a region of the photoresist, typically of the order of 20 mm × 20 mm. A wafer typically has an area of the order of 6" × 6" (15 cm × 15 cm), so in order to print the whole area of photoresist it is normally necessary to print several regions, and this is normally achieved using a "wafer stepper", in which the same lens is used to cover several regions, using a "step-and-repeat" system. The rules are generally derived assuming a perfect lens and may therefore be applied over the whole of the lens field. The lens is normally a reduction lens, and it will be understood that if, for example a 5X reduction lens is used, features on the reticle will be 5 times bigger than corresponding features printed on the photoresist.

Figure 2 shows a modelled linewidth vs. pitch function, where a line of width 0.35 µm is exposed to size at 275 mJ. That is, a reticle is used which has apertures which produce lines on the resist which are 0.35 µm wide and which are spaced by 0.7 µm, when exposed using an exposure of 275 mJ. This corresponds to the first point on the graph of Figure 2. Exposure to size means using an exposure such that the reticle and wafer (substrate) linewidths are equal, after normalising the reticle linewidth to take into account the lens magnification factor. In the example referred to above of a 5X reduction lens, what is referred to as a 0.35 µm linewidth on the reticle will be formed by exposure to size from a 1.75 µm slit on the reticle.

The graph of Figure 2 thus describes how the linewidth of the 0.35 µm line, drawn at the same size at each pitch on the reticle, varies when printed on the wafer at different pitches between dense and isolated conditions. A 1:4 line:space ratio can be considered isolated. The first point on the graph corresponds to a line:space ratio of 1:1, and the last point on the graph corresponds to a line:space ratio of about 1:6. The graph of Figure 2 thus spans from dense to isolated lines. The dense-isolated offset referred to above is the difference in linewidth between the first point on the graph (corresponding to a dense line) and the last three, all of which correspond to an isolated line.

The modelling described above assumes a perfect lens. However, lenses of wafer steppers often show linewidth variation in the printed resist image across their field at the resolution limit, caused by aberrations arising from imperfections in the lens manufacturing process. Practical results show that the dense-isolated offset and linewidth vs. pitch function can vary across the field of the lens, rendering the function shown in Figure 2 inaccurate. For instance, test measurements performed on lines having constant linewidth on the reticle (calculated to produce a linewidth of 0.4 µm on the wafer) at different positions in the image field of an I-line lens optimised for 365 nm lithography show the following linewidths on the wafer:

| Dense Line, µm | Isolated Line, µm |
|---|---|
| 0.420 | 0.403 |
| 0.429 | 0.402 |
| 0.439 | 0.473 |
| 0.438 | 0.465 |

The dense line corresponds to a line:spacing ratio of 1:1 and the isolated line to a line:spacing ratio of at least 1:4.

Linewidth vs. pitch functions such as that shown in Figure 2 can also be derived by measurement rather than simulation and, in view of the linewidth variations identified across the lens field, can be made in several parts of the wafer resulting in a series of functions (such as that in Figure 2), each of which will produce a different rules table for use in CAPROX (RTM). For example, a measurement could be made of the linewidth at each of a series of pitches in each of the four quadrants of a lens field, although it will be understood that many more measurements could be made if required.

It is possible that the multiple tables could be produced entirely by lithography simulation. However, in order to do this a detailed knowledge of lens aberrations would be necessary and stepper lens manufacturers have traditionally not supplied such information to customers. It is therefore preferred that the data files are generated based on the measured linewidths. A data file is produced for each calibrated areas of the lens field and placed appropriately during reticle manufacture. A consequence of this is that reticles become stepper-specific.

In another embodiment the data files can be produced by a combination of simulation and measurement. The central portion of a lens usually has fewer aberrations than the region around the outside. It is therefore possible to use the simulation described above for a "perfect" lens to generate a linewidth vs. pitch function, and thus data file containing rules, for the central portion of the lens field, and to determine the data files for the outer portion from measurements. For example, in the 20 mm × 20 mm field referred to above, a data file generated from a simulation could be used for the central 10 mm × 10 mm region. The outer "frame" could then be split up into 5 mm × 5 mm portions, and data files generated for each portion by measuring the variation in linewidth with pitch.

It will be appreciated that the invention is not restricted to the embodiments described above. In particular the invention can be used for any size of lens, reticle or wafer, and will equally well apply to the printing of lines of any width. Variations can be made to match specific process through the creation of new rules tables.

Furthermore, although the embodiment describes saving each rules table in a separate data file, it will be appreciated that any number, and if required all, of the rules tables could be appended to a single data file.

## Claims

1. A method of carrying out optical proximity correction in the design of a reticle for exposing a photoresist in photolithography using a lens having an image field on the photoresist, the method including:
generating a plurality of sets of rules reflecting the relationship between linewidth and line density of lines on the photoresist, each set of rules corresponding to a different region of the image field; and
carrying out optical proximity correction for each region of the image field making use of the corresponding set of rules.

2. A method as claimed in claim 1 wherein each set of rules is generated by measuring the linewidth of lines on the photoresist at a range of line densities in the corresponding region of the image field.

3. A method as claimed in claim 1 or claim 2, wherein at least one of the sets of rules is generated by a lithography simulation program arranged to simulate the relationship between the linewidth and line density of lines on the photoresist.

4. A method as claimed in claim 3, wherein the region corresponding to the set of rules generated by the lithography simulation program is located substantially in the centre of the image field.

5. A method as claimed in any preceding claim, wherein the optical proximity correction is carried out using an optical proximity correction program.

6. A method as claimed in claim 5, wherein each set of rules is stored in a separate data file.

7. A method as claimed in any preceding claim, wherein the lens is optimised for use with 365 nm lithography.

8. A reticle produced by the method of any preceding claim.

9. A polysilicon gate produced using the reticle of claim 8.
